# EUROPÄISCHE PATENTSCHRIFT

(11) **EP 2 936 583 B1**
(45) Veröffentlichungstag und Bekanntmachung des Hinweises auf die Patenterteilung: **19.04.2017**
(21) Anmeldenummer: 13836241.3
(22) Anmeldetag: 20.12.2013
(51) Int. Cl.: H01L 51/52

(54) **VERFAHREN ZUM HERSTELLEN EINES ORGANISCHEN LICHTEMITTIERENDEN BAUELEMENTES**
METHOD FOR PRODUCING AN ORGANIC LIGHT-EMITTING COMPONENT
PROCÉDÉ DE FABRICATION D'UN COMPOSANT ÉLECTROLUMINESCENT ORGANIQUE

(30) Priorität: 21.12.2012 DE 102012112999
(43) Veröffentlichungstag der Anmeldung: 28.10.2015
(73) Patentinhaber: Technische Universität Dresden, 01062 Dresden (DE)
(72) Erfinder: KIM, Yong Hyun, Busan 48059 (KR); MÜLLER-MESKAMP, Lars, 01097 Dresden (DE); LEE, Jonghee, Daejeon, 305-700, (KR); HOFMANN, Simone, 01159 Dresden (DE); KIM, Won Mok, Seoul (KR); LEO, Karl, 01219 Dresden (DE)
(74) Vertreter: Bittner, Thomas L.
(86) Internationale Anmeldenummer: PCT/DE2013/100436
(87) Internationale Veröffentlichungsnummer: WO 2014/094742

(56) Entgegenhaltungen:
- WO-A1-98/17083
- WO-A1-2004/086823
- US-A1- 2008 012 471
- SOUAD LAGHRIB ET AL: "Thermal oxidation of tin layers and study of the effect of their annealings on their structural and electrical properties", MATERIALS SCIENCE IN SEMICONDUCTOR PROCESSING, Bd. 13, Nr. 5, 12. Juni 2011 (2011-06-12), Seiten 364-370, XP028396862, ISSN: 1369-8001, DOI: 10.1016/J.MSSP.2011.04.009 [gefunden am 2011-04-28]

## Beschreibung

Die Erfindung betrifft ein Verfahren zum Herstellen eines organischen lichtemittierenden Bauelementes mit einer Schichtanordnung.

### Hintergrund

Organische lichtemittierende Bauelemente, insbesondere organische lichtemittierende Dioden (OLED), erlangen immer größere Aufmerksamkeit wegen ihres Potentials als kostengünstige und effiziente Lichtquelle. Üblicherweise verfügt ein organisches lichtemittierendes Bauelement über eine Schichtanordnung, bei der auf einem Substrat ein Schichtstapel mit einer Elektrode, einer Gegenelektrode sowie einem Stapel organischer Schichten mit einem lichtemittierenden Bereich angeordnet ist, wobei der Schichtstapel zwischen der Elektrode und der Gegenelektrode angeordnet und elektrischem Kontakt mit der Elektrode und der Gegenelektrode gebildet ist. Beim Anlegen einer elektrischen Spannung an die beiden Elektroden werden Ladungsträger in den Stapel organischer Schichten injiziert und rekombinieren dort im lichtemittierenden Bereich unter Abgabe von Licht.

Es wurde versucht, die Effizienz des Auskoppelns des in dem lichtemittierenden Bereich erzeugten Lichtes aus dem Bauelement zu optimieren. Hierzu gehört es, sogenannte Lichtauskoppelschichten auf dem Bauelement vorzusehen.

Solche Schichten sind häufig über top-down Methoden strukturiert, so wie die lithographisch hergestellten Si02 Strukturen von Sun et al., zum auskoppeln von geführten Moden (Sun et. al, Nature Photonics 2, 483-487 (2008)). Alternativ werden "emergent" modulierte Oberflächen genutzt, wie beispielsweise nanofacettierte Oberflächen von elektronenstrahlverdampften MgO bei Hong et al. (Hong et al., Advanced Materials 22, 4890-4894 (2010)). Neben einer Facettierung kann auch eine gezielte Wellung der Oberfläche (Al auf PDMS) durch Schichtspannungen zum Aukoppeln von Licht genutzt werden (Koo et al., Nature Photonics 4, 222-226 (2010)). Solche gewellten Oberflächen können auch in Photolack mittels Laserinterferenzlithographie hergestellt werden (Mattersonet et al., Advanced Materials 13, 123-127 (2001)).

Eine weitere Möglichkeit ist die Verwendung von Streupartikeln, die mit einer Matrix als Schicht ins Bauelement integriert werden können (Chang et al., Organic Electronics 13, 1073-1080 (2012), Nakamura et al., Optical review 13, 104-110 (2006)). Der Ansatz von Nakamura ist auch insofern bemerkenswert, als dass eine invertierte Streuschicht generiert wird, mit einer Matrix mit hohem Brechungsindex und Streuzentren mit niedrigem Brechungsindex. Ähnliche Systeme, die eine periodische Ordnung und die damit verbundenen photonischen Effekte aufweisen, können mittels Aufbringen von Silica-Mikrokugeln erreicht werden (Yamasaki et al., Applied Physics Letters 76, 1243 (2000)). Eine noch höhere Ordnung weisen photonische Kristallsysteme auf, wie sie beispielsweise durch Lithographie und Trockenätzen im System SiO2 / SiNx hergestellt wurden (Do et al., Advanced Materials 15, 1214-1218 (2003)).

Neben diesen integrierten Ansätzen zur Auskopplung bestehen externe Ansätze wie das Aufbringen eines Mikrolinsenarrays (Möller et al., Journal of applied physics 91, 3324 (2002)) oder Mikrolinsenfolien (Thomschke et al., Nano Letters (2012)).

Im Dokument DE 10 2008 048 161 A1 ist ein optoelektronisches organisches Bauteil offenbart. Beim Herstellen des Schichtaufbaus des Bauelementes wird mittels Tauchbeschichten eine Schicht mit Streupartikeln gebildet, die zuvor hergestellt und dann in ein Beschichtungs-Sol eingerührt wurden.

Das Dokument US 2008/0029147 A1 betrifft eine Elektrode für ein elektrooptisches Bauelement. Die Elektrode weist eine Benetzungsschicht aus einem elektrisch leitendem Material auf einem Substrat auf. Eine zweite Schicht eines elektrisch leitenden Materials wird auf der Benetzungsschicht hergestellt. Die Benetzungsschicht weist eine erste Benetzungseigenschaft bezüglich der Oberfläche des Substrats auf. Die zweite Schicht verfügt über eine zweite Benetzungsfähigkeit bezüglich der Oberfläche des Substrats. Die Benetzungseigenschaften unterscheiden sich. Die Benetzungsschicht ändert eine optische Eigenschaft der Elektrode aufgrund der Benetzungsfähigkeit.

Aus dem Dokument WO 2004 / 086823 A1 ist ein elektrolumineszentes Bauteil mit einer Schichtanordnung bekannt, in welcher eine Funktionsschicht mit elektrisch leitenden Partikeln vorgesehen ist. Auch das Dokument US 2008 / 0012471 A1 betrifft ein organisches lichtemittierendes Bauelement (OLED) mit einer Streuschicht.

Im Dokument WO 98 / 17083 A1 ist ein Beleuchtungssystem offenbart, welches ein Substrat und eine aktive Schicht aufweist, die ein elektroluminszentes Material enthält, wobei die aktive Schicht zwischen einer ersten, optisch transparenten Elektrodenschicht und einer zweiten Elektrodenschicht angeordnet ist.

Neben künstlichen Auskoppelstrukturen wurde die Brechungsindexanpassung mittels Materialauswahl vorgeschlagen. Die organischen lichtemittierenden Bauelemente werden häufig auf einem Glassubstrat hergestellt, wobei Indiumzinnoxid (ITO) oft als Elektrodenmaterial eingesetzt wird. ITO-Elektroden verstärken die innere Totalreflexion am Übergang zwischen Glas (n = 1,5) und ITO (n = 2,0). Hierdurch ist die Effizienz der Lichtauskopplung bei herkömmlichen organischen lichtemittierenden Bauelementen begrenzt, die das Licht durch die Grundelektrode absenden (bottom-emittierend). Ein weiteres Problem ergibt sich durch den Brechungsindex der organischen Schicht selbst, die ebenfalls im Bereich (n=1,8-2) liegt. Durch die Nutzung eines Substrats mit hohem Brechungsindex (n > 1,8) reduziert sich die 10 innere Totalreflexion am Übergang zwischen Glas und ITO-Elektrode deutlich und das im Substrat geführte Licht kann durch Auskoppelstrukturen an der Oberfläche effizient abgestrahlt werden. Substrate mit einem hohen Brechungsindex sind jedoch für die kostengünstige Massenproduktion von OLEDs nicht geeignet wegen der hohen Materialkosten. Ohne Auskoppelstrukturen tritt darüber hinaus eine ungewünschte Totalreflexion am Übergang zwischen Luft und Glassubstrat auf, was seine Ursache in einem hohen Brechungsindexunterschied hat.

Ein weiterer Versuch zur Auskopplungsverstärkung sieht die Reduzierung der optischen Mikro-Kavität vor, indem leitende Polymerelektroden mit niedrigem Brechungsindex verwendet werden. Ein ähnlicher Ansatz ist auch die Verwendung von Oxid / Metall / Oxid Elektroden, die aufgrund der geringen Schichtdicke und angepassten Dünnschichtoptik ebenfalls eine effiziente Auskopplung ermöglichen.

Wegen der beschriebenen Nachteile und Einschränkungen besteht weiterhin Bedarf für die Optimierung der Lichtauskopplung bei organischen lichtemittierenden Bauelementen, wobei einige der oben beschriebenen Konzepte mit den hier behandelten Streuschichten kombiniert werden könnten.

### Zusammenfassung

Aufgabe der Erfindung ist es, ein Verfahren zum Herstellen eines organischen lichtemittierenden Bauelementes mit einer Schichtanordnung anzugeben, mit denen die Effizienz für das Auskoppeln des im Bauelement erzeugten Lichtes verbessert wird.

Diese Aufgabe wird erfindungsgemäß gelöst durch ein Verfahren zum Herstellen eines organischen lichtemittierenden Bauelementes mit einer Schichtanordnung nach dem unabhängigen Anspruch 1. Vorteilhafte Ausgestaltungen sind Gegenstand von abhängigen Unteransprüchen.

Nach einem Aspekt ist ein Verfahren zum Herstellen eines organischen Bauelementes mit einer Schichtanordnung geschaffen, bei dem ein Substrat bereitgestellt und auf dem Substrat ein Schichtstapel hergestellt wird. Der Schichtstapel wird mit einer Elektrode, einer Gegenelektrode sowie organischen Schichten mit einem lichtemittierenden Bereich auf dem Substrat hergestellt. Hierbei werden die organischen Schichten zwischen der Elektrode und der Gegenelektrode und in elektrischem Kontakt mit der Elektrode und der Gegenelektrode gebildet. Die Schichtanordnung wird hergestellt mit einer Licht streuenden Funktionsschicht mit flächig zufällig verteilten Metalloxid-Partikeln.

Bei dem Verfahren ist vorgesehen, dass zum Herstellen der Licht streuenden Funktionsschicht eine Metallschicht abgeschieden und die Metallschicht erwärmt wird, derart, dass aus der zuvor abgeschiedenen Metallschicht die flächig zufällig verteilten Metalloxid-Partikel gebildet werden.

Das Erwärmen oder Erhitzen der zuvor aufgebrachten Metallschicht, bei der es sich zum Beispiel um eine Zinnschicht handeln kann, kann ein- oder mehrstufig erfolgen.

Die Metalloxid-Partikel können vereinzelt gebildet sein, also beabstandet voneinander, oder eine im Wesentlichen geschlossene Schicht bilden. Die Metalloxid-Partikel streuen das im Bauelement erzeugte Licht. Die Licht streuende Wirkung der Metalloxid-Partikel kann auf einem Brechungsindexunterschied zwischen dem Brechungsindex der Metalloxid-Partikel einerseits und dem Brechungsindex des die Metalloxid-Partikel umgebenden Materials andererseits beruhen. Die Metalloxid-Partikel können den höheren Brechungsindex aufweisen. Aber auch eine Ausführung kann vorgesehen sein, bei der der Brechungsindex des umgebenden Materials höher als der Brechungsindex der Metalloxid-Partikel ist. Der Brechungsindexunterschied kann mindestens etwa 0.2 betragen. Die Umgebung der Metalloxid-Partikel kann von einer oder mehreren Glättungsschichten gebildet sein.

Der Schichtstapel kann zwischen den Elektroden neben den organischen Schichten eine oder mehrere anorganischen Schichten aufweisen, zum Beispiel metallische oder oxidische Schichten.

Die Elektroden können ein- oder mehrschichtig ausgeführt sein, zum Beispiel kann zumindest eine der Elektroden eine oder mehrere dünne Metallschichten aufweisen.

Neben dem lichtemittierenden Bereich umfasst der Stapel organischer Schichten ein oder mehrere Transportschichten, die als Elektronen- oder Lochtransportschicht ausgeführt sind. Es kann vorgesehen sein, die Transportschichten elektrisch zu dotieren. Es können alternativ oder ergänzend Transportschichten als dünne Metalloxidschichten gebildet sein.

Beim nachfolgenden Schichtaufbau werden die zuvor auf der darunterliegenden Schicht hergestellten Metalloxid-Partikel in das Material einer oder mehrerer folgender Schichten eingebettet, also zumindest teilweise hiervon bedeckt. Hierdurch entsteht letztlich ein Schichtaufbau, bei dem eine Mischschicht gebildet ist mit den Metalloxid-Partikeln, die vereinzelt angeordnet sein können, und dem Material der einen oder der mehreren nachfolgenden Schichten, zum Beispiel dem Material einer oder mehrerer Glättungsschichten.

Eine bevorzugte Weiterbildung sieht vor, dass die Licht streuende Funktionsschicht zwischen dem Substrat und der Elektrode hergestellt wird, die eine Grundelektrode bildet. Bei dieser Ausführungsform kann die Funktionsschicht, wahlweise zusammen mit einer oder mehreren Glättungsschichten, direkt auf dem Substrat angeordnet sein, beispielsweise einem Glassubstrat. Bei dieser oder anderen Ausführungsformen kann die Funktionsschicht aus Zinnoxid-Partikeln gebildet sein. Es kann vorgesehen sein, dass die Elektrode, bei der es sich hier um die Grundelektrode handelt, direkt auf die Funktionsschicht oder die wahlweise hierauf gebildete Glättung aufgebracht ist.

Bei einer zweckmäßigen Ausgestaltung kann vorgesehen sein, dass die Licht streuende Funktionsschicht zwischen der Elektrode und der Gegenelektrode gebildet wird. Bei dieser Ausführungsform kann die Funktionsschicht in dem Stapel organischer Schichten angeordnet sein. Die Funktionsschicht kann oberhalb oder unterhalb des lichtemittierenden Bereiches zwischen den beiden Elektroden angeordnet sein.

Eine vorteilhafte Ausführungsform sieht vor, dass die Licht streuende Funktionsschicht oberhalb der Gegenelektrode hergestellt wird, die eine Deckelektrode bildet. Bei dieser Ausführungsform befindet sich die Funktionsschicht außerhalb der Anordnung mit Elektrode und Gegenelektrode sowie hierzwischen angeordnetem Stapel organischer Schichten. Es kann vorgesehen sein, dass die Funktionsschicht direkt auf der Deckelektrode gebildet ist. Alternativ können zwischen Deckelektrode und Funktionsschicht ein oder mehrere Zwischenschichten angeordnet sein. Oberhalb der Funktionsschicht, die wahlweise mit einer Glättung versehen ist, kann eine Bauelementkapselung vorgesehen sein.

Bevorzugt sieht eine Fortbildung vor, dass die Licht streuende Funktionsschicht auf einer von dem Schichtstapel abgewandten Substratseite gebildet wird. Bei dieser Ausführungsform ist die Funktionsschicht auf einer Unterseite des Substrates angeordnet, die von dem Schichtstapel abgewandt ist. Licht, was durch das Substrat gelangt, tritt in Wechselwirkung mit der Funktionsschicht.

Bei einer vorteilhaften Ausgestaltung kann vorgesehen sein, dass die Metalloxid-Partikel als Metalloxid-Nanocluster gebildet werden. Die Nanocluster können eine Größe von etwa 10 nm bis etwa mehrere 100 nm aufweisen.

Eine Weiterbildung kann vorsehen, dass die Funktionsschicht als eine Lichtauskoppelschicht hergestellt wird.

Eine bevorzugte Weiterbildung sieht vor, dass auf der Licht streuenden Funktionsschicht wenigstens eine Glättungsschicht hergestellt wird, derart, dass die wenigstens eine Glättungsschicht erhabene Strukturen der Funktionsschicht zumindest teilweise geglättet. Die erhabenen Strukturen sind insbesondere durch die Metalloxid-Partikel gebildet. Diese werden von der Glättungsschicht dann wenigstens teilweise eingebettet. Es kann vorgesehen sein, dass mittels der Glättung für eine nachfolgende Schicht in der Schichtanordnung eine glatte Oberfläche bereitgestellt wird. Bei der wenigstens einen Glättungsschicht kann es sich um eine transparente Schicht handeln, zum Beispiel eine Polymerschicht. Die wenigstens eine Glättungsschicht kann mit einer Dicke im µm-Bereich gebildet sein. Die wenigstens eine Glättungsschicht, welche die Umgebung für die Metalloxid-Partikel bildet, kann einen Brechungsindex von etwa 1.0 bis etwa 1.9, bevorzugt von etwa 1.2 bis etwa 1.9 und weiter bevorzugt von etwa 1.2 bis etwa 1.7 aufweisen, insbesondere bezogen auf den sichtbaren Wellenlängenbereich. Falls die Glättungsschicht(en) nicht vorgesehen ist, kann eine derart ausgeführte Brechungsindex-Umgebung auch mit der oder den folgenden Schichten des Stapels hergestellt werden.

In einer Ausführung können die erhabenen Strukturen, unabhängig davon, ob ein oder mehrere Glättungsschichten vorgesehen sind, zu einer oberhalb der Licht streuenden Funktionsschicht ausgebildeten, sich durch alle Folgeschicht hindurch erstreckenden Schichtunebenheit (Flächenrauigkeit) führen. Diese Unebenheit kann sich für die betroffenen Schichten in unterschiedlichem Umfang bis zur Deckschicht hin erstrecken, sei dies zum Beispiel die Deckelektrode, eine Bauelementkapselung oder eine andere äußere Schicht.

Bei einer zweckmäßigen Ausgestaltung kann vorgesehen sein, dass die Schichtanordnung mindestens eine weitere Funktionsschicht aufweist, die mit flächig zufällig verteilten Metalloxid-Partikeln gebildet wird. In Verbindung mit der mindestens einen weiteren Funktionsschicht, die mit Metalloxid-Partikeln gebildet ist, gelten die im Zusammenhang mit der Funktionsschicht gemachten Erläuterungen entsprechend.

Die eine oder die mehreren Funktionsschichten mit den Metalloxid-Partikeln können bei dem Bauelement kombiniert werden mit anderen Funktionsschichten, insbesondere auch Funktionsschichten zur Umsetzung weiterer Lichtauskoppeltechniken.

Es kann vorgesehen sein, dass beim Herstellen der Licht streuenden Funktionsschicht ein mehrstufiger Temperprozess ausgeführt wird, welcher einen Temperschritt im Vakuum und später einen Temperschritt in Luft- oder Sauerstoffumgebung umfasst. Zum Beispiel kann die als Film abgeschiedene Metallschicht zunächst in einer Vakuumumgebung erwärmt werden (erhitzen). Hierbei können sich Metallcluster bilden. Hierauf kann, zeitlich versetzt oder gleich im Anschluss, ein weiterer Behandlungsschritt zum Erwärmen in einer Luft- oder Sauerstoffumgebung vorgesehen sein, insbesondere zur Oxidation des Metallmaterials. Die abgeschiedene Metallschicht kann mit einer Schichtdicke von etwa 100 nm bis etwa 500 nm hergestellt werden. Das ein- oder mehrstufige Erwärmen führt zur Ausbildung der Licht streunende Struktur. Es kann dazu führen, dass die zuvor vorzugsweise geschlossen gebildete Metallschicht in vereinzelte Partikel umgewandelt wird, die voneinander beabstandet sind. Auch können alternative oder ergänzend poröse Nanostrukturen gebildet werden.

In Verbindung mit dem Herstellen der Funktionsschicht aus den Metalloxid-Partikeln auf einem Substrat können ein oder mehrere der folgenden Schritte vorgesehen sein. Insbesondere kann nach dem Herstellen der Funktionsschicht eine Glättungsschicht aufgebracht werden. In einem Schritt wird auf dem Substrat, bei dem es sich zum Beispiel um ein Glassubstrat handelt, eine Metallschicht abgeschieden. In einem folgenden Schritt wird der Verbund aus Substrat und Metallschicht in einer Vakuumumgebung erhitzt, sodass sich Metall-Partikel bilden. In einem weiteren Schritt wird das Zwischenprodukt erneut erhitzt, nun vorzugsweise in einer Luftumgebung, wodurch die Metall-Partikel oxidiert werden, sodass Metalloxid-Partikel entstehen. Im folgenden Schritt kann eine Glättungsschicht aufgetragen werden. Bei der erläuterten Ausführung wird mit Hilfe der Glättungsschicht eine glatte Oberfläche für den folgenden Schichtauftrag bereitgestellt. Mit Hilfe der Metalloxid-Partikel und der Glättungsschicht ist eine geglättete Funktionsschicht hergestellt, auf der der weitere Schichtaufbau erfolgen kann. Bei dem weiteren Schichtauftrag kann eine Elektrode auf der Glättungsschicht abgeschieden werden.

Im Zusammenhang mit dem organischen lichtemittierenden Bauelement gelten hinsichtlich möglicher Ausgestaltungen die in Verbindung mit dem Verfahren gemachten Erläuterungen entsprechend.

### Beschreibung von Ausführungsbeispielen

Im Folgenden werden weitere Ausführungsbeispiele unter Bezugnahme auf Figuren einer Zeichnung näher erläutert. Hierbei zeigen:
- Fig. 1: eine schematische Darstellung einer Schichtanordnung eines organischen lichtemittierenden Bauelementes mit einer geglätteten Funktionsschicht, die zwischen einem Substrat und einer Grundelektrode angeordnet ist,
- Fig. 2: eine schematische Darstellung einer Schichtanordnung für ein organisches lichtemittierendes Bauelement, bei dem die geglättete Funktionsschicht zwischen der Grund- und der Deckelektrode angeordnet sind,
- Fig. 3: eine schematische Darstellung einer Schichtanordnung für ein organisches lichtemittierendes Bauelement, bei dem die geglättete Funktionsschicht auf der Deckelektrode angeordnet ist,
- Fig. 4: eine schematische Darstellung einer Schichtanordnung für ein organisches lichtemittierendes Bauelement, bei dem die geglättete Funktionsschicht auf einer Unterseite des Substrats angeordnet ist,
- Fig. 5: eine schematische Darstellung einer Schichtanordnung für ein organisches lichtemittierendes Bauelement,
- Fig. 6: eine schematische Darstellung zur Herstellung einer Funktionsschicht mit vereinzelten Metalloxid-Partikeln,
- Fig. 7: experimentelle Ergebnisse von AFM- und SEM-Untersuchungen,
- Fig. 8: eine grafische Darstellung des Transmissionsvermögens in Abhängigkeit von der Wellenlänge für ein Funktionsschichtsystem,
- Fig. 9: eine grafische Darstellung der Stromdichte in Abhängigkeit von der Spannung für organische lichtemittierende Bauelemente mit Licht streuender Funktionsschicht,
- Fig. 10: eine grafische Darstellung der externen Quanteneffizienz in Abhängigkeit von der Leuchtdichte für organische lichtemittierende Bauelemente mit Licht streuender Funktionsschicht,
- Fig. 11: eine grafische Darstellung der normierten spektralen Intensität in Abhängigkeit von der Wellenlänge bei verschiedenen Betrachtungswinkeln für ein organisches lichtemittierendes Bauelement mit Licht streuender Funktionsschicht,
- Fig. 12: eine grafische Darstellung der normierten spektralen Intensität in Abhängigkeit von der Wellenlänge bei verschiedenen Betrachtungswinkeln für ein organisches lichtemittierendes Bauelement ohne Licht streuender Funktionsschicht (Referenz),
- Fig. 13: eine grafische CIE-Darstellung für verschiedene organische lichtemittierende Bauelemente mit und ohne Licht streuende Funktionsschicht und
- Fig. 14: experimentelle Ergebnisse für die externe Quanteneffizienz in Abhängigkeit von der Leuchtstärke bei Anwendung einer halbkugelförmigen Linse am Glassubstrat für die verschiedenen organischen lichtemittierenden Bauelemente aus Fig. 13.

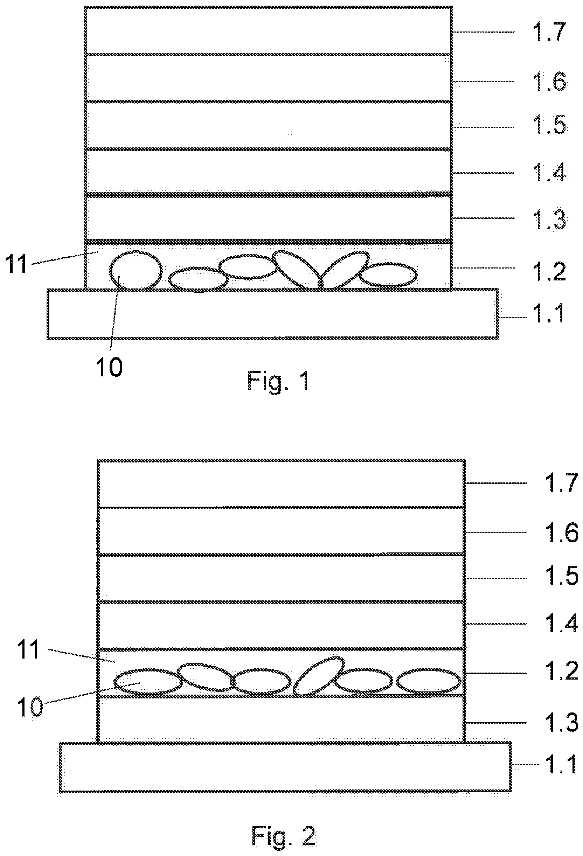

Fig. 1 zeigt eine schematische Darstellung einer Schichtanordnung für ein organisches lichtemittierendes Bauelement, zum Beispiel eine organische lichtemittierende Diode (OLED), mit einer geglätteten Funktionsschicht 1.2, die zwischen einem Substrat 1.1 und einer Grundelektrode 1.3 angeordnet ist. Die geglättete Funktionsschicht 1.2 bildet ein Schichtsystem und weist vereinzelte Metalloxid-Partikel 10 in einem Schichtmaterial einer Glättungsschicht 11 auf. Auf die geglättete Funktionsschicht 1.2 ist im gezeigtem Beispiel eine organische lichtemittierende Diode aufgebracht mit einer Grundelektrode 1.3, einer ersten Ladungsträgertransportschicht 1.4, einem lichtemittierenden Bereich 1.5, einer zweiten Ladungsträgertransportschicht 1.6 sowie einer Deckelektrode 1.7.

Fig. 2 zeigt eine schematische Darstellung einer Schichtanordnung für ein organisches lichtemittierende Bauelement, bei dem die geglättete Funktionsschicht 1.2 zwischen der Grund- und der Deckelektrode 1.3, 1.7 angeordnet ist, also im Stapel der organischer Schichten 1.4 bis 1.6.

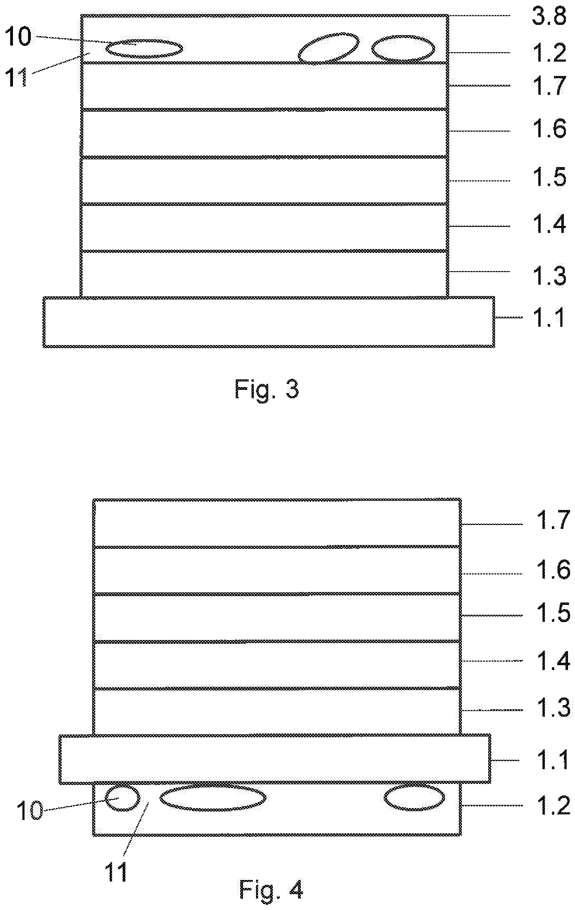

Fig. 3 zeigt eine schematische Darstellung einer Schichtanordnung für ein organisches lichtemittierendes Bauelement, bei dem die geglättete Funktionsschicht 1.2 auf der Deckelektrode 1.7 angeordnet ist.

Fig. 4 zeigt eine schematische Darstellung einer Schichtanordnung für ein organisches lichtemittierendes Bauelement, bei dem die geglättete Funktionsschicht 1.2 auf einer Unterseite 12 des Substrats 1.1 angeordnet ist.

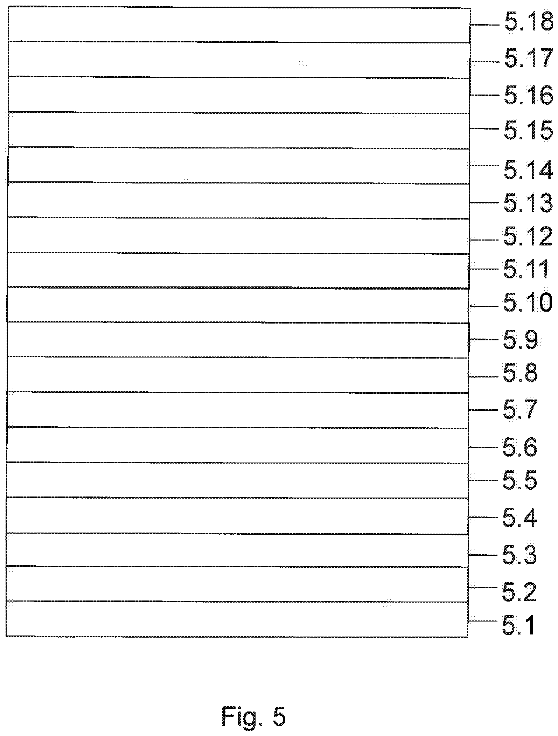

Fig. 5 zeigt eine schematische Darstellung für eine Schichtanordnung eines organischen, weißes Licht emittierenden Bauelementes, für das der folgende Aufbau gewählt wurde:
- 5.1:: Glassubstrat
- 5.2:: Licht streuende Schicht mit Metalloxid-Partikeln
- 5.3:: Glättungsschicht
- 5.4:: Poly(3,4-ethylenedioxythiophene):poly(styrenesulfonate) (PEDOT:PSS) (Schichtdicke: 58 nm)
- 5.5:: (N,N,N',N'-tetrakis(4-methoxyphenyl)-benzidine) (MeO-TPD): - (perfluoronaphthalene-2,6-diylidene)dimalononitrile (F6-TCNNQ) (2 Gew.%) (35 nm)
- 5.6:: 2,2',7,7'-tetrakis-(N,N'-diphenylamino)-9,9'-spirobifluorene (Spiro-TAD) (10 nm)
- 5.7:: N,N'-di-1-naphthalenyl-N,N'-diphenyl-[1,1':4',1":4",1"'-Quaterpheny]1-4,4"'-diamine (4P-NPD):Iridium(III)bis(2-methyldibenzo-[f,h]chinoxalin)(acetylacetonat) (Ir(MDQ)₂(acac)) (5 Gew.%) (5 nm)
- 5.8:: 4P-NPD (3 nm)
- 5.9:: 4,7-diphenyl-1,10-phenanthroline (BPhen) (Schichtdicke: 10 nm)
- 5.10:: BPhen:Cs (1:1) (90 nm)
- 5.11:: Ag (0.5 nm)
- 5.12:: MeO-TPD:F6-TCNNQ (2 Gew.%) (75 nm)
- 5.13:: Spiro-TAD (10 nm)
- 5.14:: 4,4',4" tris(N-carbazolyl)-triphenylamine (TCTA):fac-tris(2-phenylpyridine) iridium(III) (Ir(ppy)₃):bis(2-(9,9-dihexylfluorenyl)-1-pyridine) (acetylacetonate) iridium(III) (Ir(dhfpy)₂(acac)) (91:8:1 Gew.%) (5 nm)
- 5.15:: 2,2'2"-(1,3,5-benzenetriyl)-tris[1-phenyl-1H-benzimidazole] (TPBI):Ir(ppy)3:Ir(dhfpy)2(acac) (91:8:1 Gew.%) (5 nm)
- 5.16:: TPBI (10 nm)
- 5.17:: BPhen:Cs (1:1) (60 nm)
- 5.18:: All (100 nm)

Die in Fig. 5 als Ausführungsbeispiel gezeigte OLED besteht aus den Funktionseinheiten Substrat (5.1), Licht streuende Metalloxid-Partikel-Schicht (5.2), Glättungsschicht (5.3), Polymerelektrode (5.4). Darauf ist eine "Triplett-Harvesting-Unit" zur Rot- / Blauemission aufgebracht, bestehend aus einer Löchertransportschicht (5.5), einer Elektronen-Blockschicht (5.6), einer Emitterschicht (5.7) mit einem roten Emitter in der Matrix, einer weiteren Emitterschicht (5.8) mit einem blauen Emittier, einer Blockschicht (5.9) und einer Transportschicht (5.10). Hierauf folgt eine gelb / grün emittierende Einheit (5.14 / 5.15) mit den entsprechenden Transport- und Blockschichten. Als Deckelektrode wird eine opake Metallschicht (5.18) verwendet.

Zur Herstellung des organischen lichtemittierenden Bauelementes wurde ein Metallfilm aus Zinn mit einer Dicke von 300 nm auf einem Glassubstrat bei Raumtemperatur mittels Sputtern abgeschieden. Der Metallfilm wurde dann in einer Vakuumumgebung (10⁻³ mbar) bei 300 °C für 30 min erhitzt. In einem weiteren Schritt wurde anschließend in Luftumgebung bei 500 °C für 1 h erhitzt. Die hierdurch erhaltene Schicht vereinzelter Zinnoxid-Partikel, die in zufälliger Anordnung über die Oberfläche des Glassubstrats verteilt sind, wurde danach mit einer Glättungsschicht aus einem Polymermaterial bedeckt. Hierzu wurde ein Photolack (auf Basis von Propylen-Glycol-Monomethyl-AtherAcetat verwendet. Die so erhaltene Filmschicht wurde auf einer heißen Platte bei 130 °C für 10 min erwärmt. Als Material für die leitende Elektrode wurde PEDOT:PSS mit 6 Vol.% Ethylenglycol mittels Spincoating aufgetragen. Der Schichtstapel wurde 120 °C für 15 min gebacken.

Das Transmissionsvermögen wurde mittels eines Spektrometers untersucht. Rasterkraftmikroskop-Untersuchungen (AFM - "Atomic Force Microscopy") wurden ebenfalls aufgenommen. Darüber hinaus wurden REM-Bilder (Rasterelektronenmikroskop) aufgenommen.

Auf das so hergestellte Schichtsystem, was insoweit eine geglättete Funktionsschicht mit den Metalloxid-Partikeln bereitstellt, wurde anschließend eine organische lichtemittierende Diode aufgebracht. Hierbei wurden die organischen Schichten mittels thermischer Verdampfung in einer Vakuumumgebung abgeschieden. Um Restwasser in der PEDOT:PSS - Elektrode zu entfernen, wurde das Bauelement für 120 min in einer Vakuumkammer bei 110 °C unmittelbar vor dem Abscheiden der organischen Schichten erhitzt. Nach dem Abscheiden der Schichten des organischen lichtemittierenden Bauelementes erfolgte eine Kapselung mit einem Deckglas.

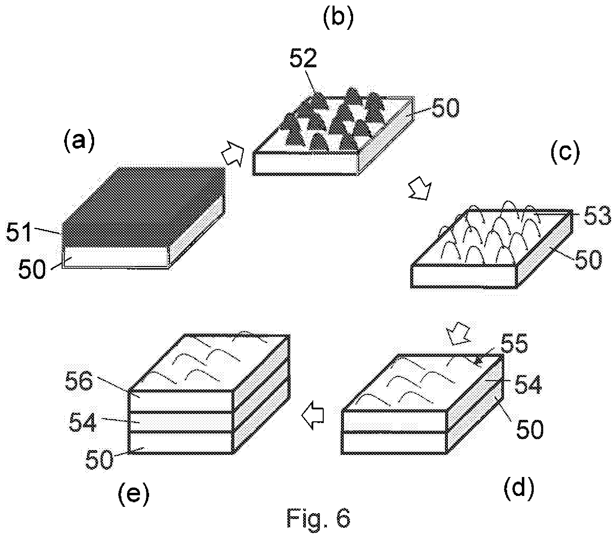

Fig. 6 zeigt eine schematische Darstellung in Verbindung mit dem Herstellen der Funktionsschicht aus den Metalloxid-Partikeln auf einem Substrat und dem anschließenden Aufbringen einer Glättungsschicht. In einem Schritt (a) wird auf dem Substrat 50, bei dem es sich zum Beispiel um ein Glassubstrat handelt, eine Metallschicht 51 abgeschieden. In einem folgenden Schritt (b) wird der Verbund aus Substrat 50 und Metallschicht 51 in einer Vakuumumgebung erhitzt, sodass sich Metall-Partikel 52 bilden. In einem weiteren Schritt (c) wird das Zwischenprodukt erneut erhitzt, nun in einer Luftumgebung, wodurch die Metall-Partikel 52 oxidiert werden, sodass Metalloxid-Partikel 53 entstehen. Im folgenden Schritt (d) wird eine Glättungsschicht 54 aufgetragen. Bei der gezeigten Ausführung wird mit Hilfe der Glättungsschicht 54 eine glatte Oberfläche 55 für den folgenden Schichtauftrag bereitgestellt. Mit Hilfe der Metalloxid-Partikel 53 und der Glättungsschicht 54 ist eine geglättete Funktionsschicht hergestellt, auf der der weitere Schichtaufbau erfolgen kann. Bei diesem Schichtauftrag wird dann im gezeigten Beispiel gemäß Schritt (e) eine Elektrode 56 auf der Glättungsschicht 54 abgeschieden.

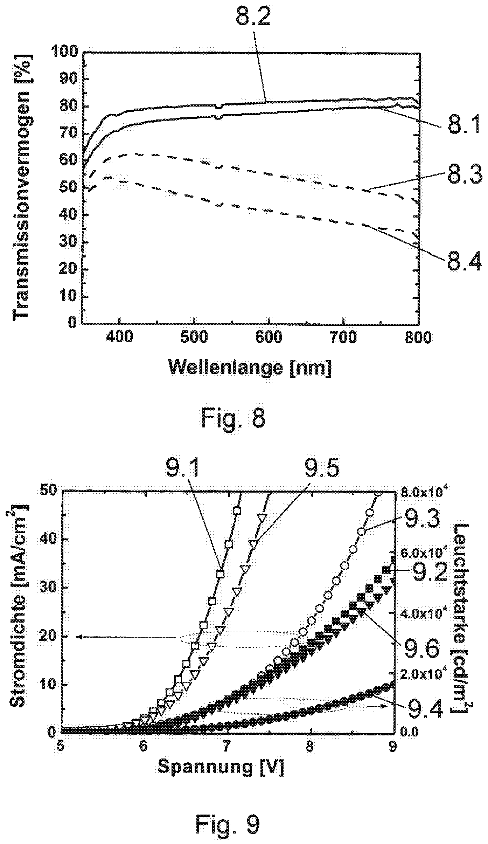

Fig. 8 zeigt eine grafische Darstellung für das relative Transmissionsvermögen in Abhängigkeit von der Wellenlänge für einen derart hergestellten Schichtaufbau mit Substrat, Metalloxid-Partikeln und Glättungsschicht sowie einer Ausführungsform, bei der es an der Glättungsschicht fehlt. Die oberen Kurven 8.1 und 8.2 betreffen die Gesamttransmission, wohingegen die unteren Kurven 8.3 und 8.4 den diffusen Anteil des Transmissionsvermögens betreffen. Die Kurven 8.1 und 8.3 zeigen die Ergebnisse für den Schichtaufbau (Substrat und hierauf befindliche Metalloxid-Partikel) ohne Glättungsschicht. Die Kurven 8.2 und 8.4 betreffen den Schichtaufbau mit Substrat, Metalloxid-Partikeln und Glättungsschicht.

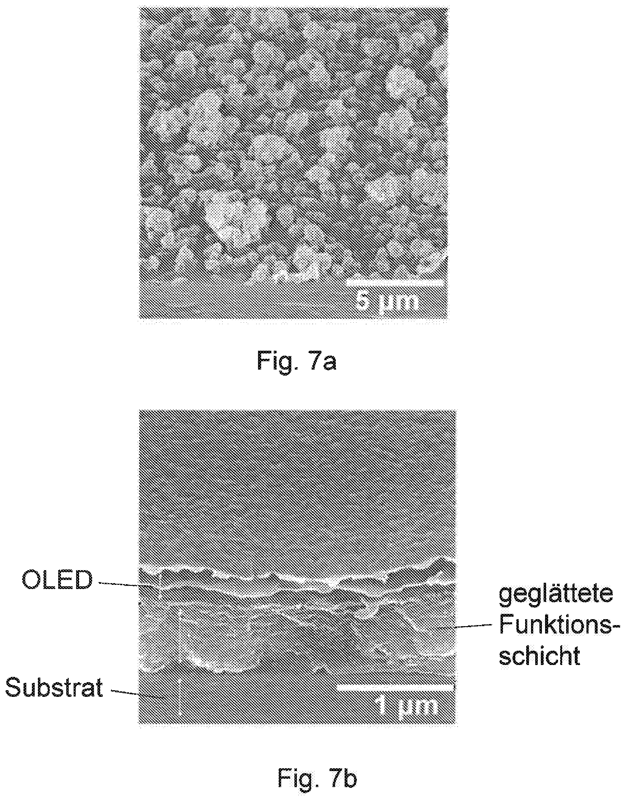

Fig. 7 zeigt Ergebnisse von SEM-Messungen. Fig. 7a zeigt die Funktionsschicht mit den Metalloxid-Partikeln ohne Glättungsschicht. Fig. 7b zeigt die Schichtanordnung, bei der auf dem Glassubstrat die geglättete Funktionsschicht mit Metalloxid-Partikeln sowie eine weißes Licht abgebende organische lichtemittierende Diode angeordnet sind.

Es wurden weitere organische lichtemittierende Bauelemente hergestellt. Für diese wurde grundsätzlich der Schichtaufbau gemäß Fig. 5 gewählt.

Zum Referenzvergleich wurde ein Bauelement hergestellt, bei dem die Grundelektrode aus ITO besteht (Referenz 1). Es fehlte bei diesem Bauelement darüber hinaus an der Licht streuenden Funktionsschicht 5.2. Als weiteres Referenzbauelement (Referenz 2) wurde ein Schichtaufbau gewählt, bei dem es auch an der Licht streuenden Funktionsschicht 5.2 fehlte, wobei als Grundelektrode eine PEDOT:PSS - Elektrode zum Einsatz kommt.

Die Fig. 9 bis 12 zeigen experimentelle Ergebnisse für die drei verschiedenen organischen lichtemittierenden Bauelemente.

In Fig. 9 betreffen die Kurven 9.1 und 9.2 das Bauelement nach Referenz 1. Die Kurven 9.3 und 9.4 betreffen das Bauelement nach Referenz 2. Die Kurven 9.5 und 9.6 beziehen sich auf das Bauelement gemäß Fig. 5.

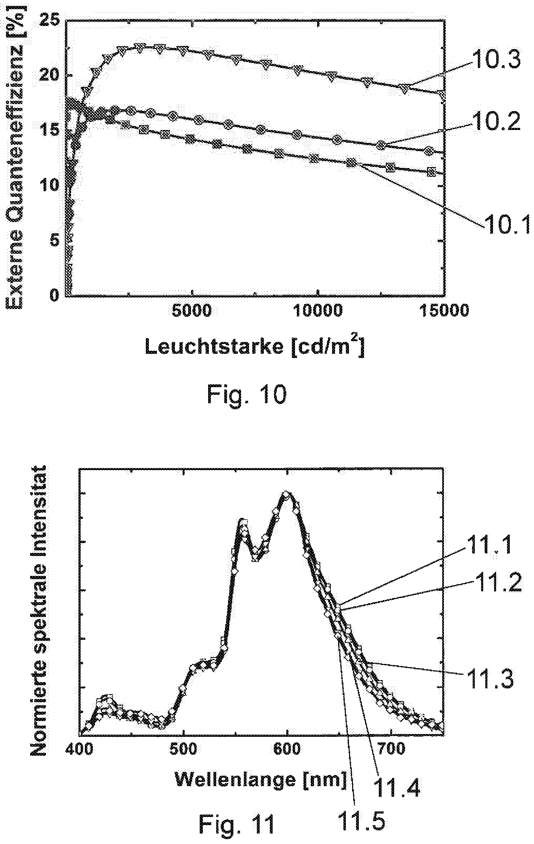

In Fig. 10 betrifft die Kurve 10.1 das Bauelement nach Referenz 1. Die Kurve 10.2 bezieht sich auf das Bauelement nach Referenz 2. Schließlich zeigt die Kurve 10.3 die Ergebnisse für das Bauelement nach Fig. 5. Es zeigt sich, dass durch die Verwendung der Funktionsschicht im Bauelement nach Fig. 5 eine deutliche Verbesserung der externen Quanteneffizienz im Vergleich zu den Referenzen erreicht werden kann.

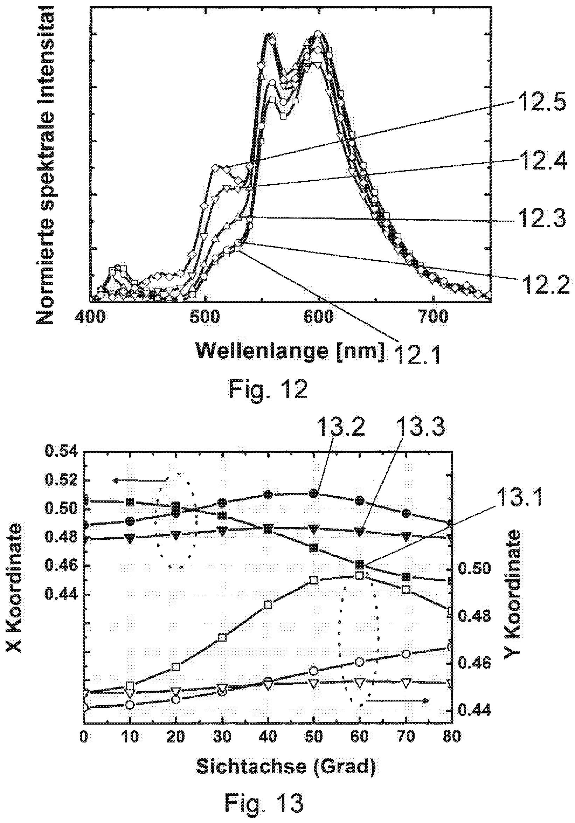

Fig. 11 zeigt eine grafische Darstellung der normierten spektralen Intensität für verschiedene Betrachtungswinkel für das Bauelement nach Fig. 5. Es zeigt sich, dass nur sehr geringe Verschiebungen in Abhängigkeit vom Betrachtungswinkel auftreten. Dieses ist bei dem Referenz-Bauelement nach Referenz 1 gemäß Fig. 12 anders.

In Fig. 13 ist die Verschiebung des Farbpunktes mit dem Winkel für die drei Bauelemente aufgetragen. Die Kurve 13.1 bezieht sich auf das Bauelement nach Referenz 1. Die Kurve 13.2 betrifft das Bauelement nach Referenz 2. Schließlich zeigt die Kurve 13.3 die Ergebnisse für das Bauelement nach Fig. 5, welches wesentlich stabilere Farbkoordinaten zeigt.

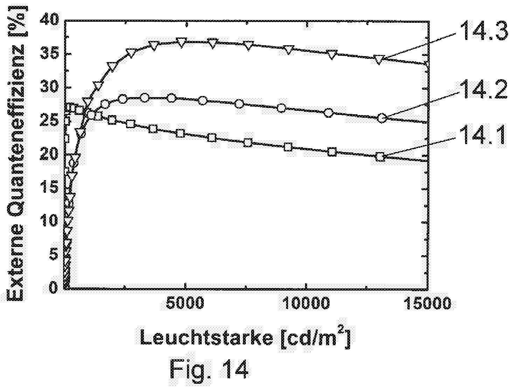

Weiterhin wurde untersucht, wie sich eine halbkugelförmige Linse auf die Messungen an den Bauelementen auswirkt, um das Potential der Technologie weiter zu untersuchen. Fig. 14 zeigt experimentelle Ergebnisse für die externe Quanteneffizienz (EQE) in Abhängigkeit von der Leuchtstärke (cd/m²) bei Anwendung der halbkugelförmigen Linse am Glassubstrat. Kurve 14.1 bezieht sich auf das Bauelement nach Referenz 1, wohingegen die Kurve 14.2 das Bauelement nach Referenz 2 betrifft. Die Kurve 14.3 zeigt dann das Ergebnis für das Bauelement nach Fig. 5.

Die folgende Tabelle fasst die Ergebnisse für den Vergleich der Messungen mit und ohne halbkugelförmige Linse zusammen.

| | Ohne Linse | | | Mit Linse | | |
|---|---|---|---|---|---|---|
| @10000 cd/m² | lm/W | EQE | EQE-Erhöhung | lm/W | EQE | EQE-Erhöhung |
| Referenz 1 | 14.5 | 12.3 | x | 25.4 | 20.8 | 1.8 |
| Referenz 2 | 13.1 | 14.3 | 1.2 | 26.1 | 26.6 | 2.2 |
| Fig. 5 | 22.7 | 20.3 | 1.7 | 41.6 | 35.6 | 2.9 |

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungen von Bedeutung sein.

## Patentansprüche

1. Verfahren zum Herstellen eines organischen Bauelementes mit einer Schichtanordnung, wobei das Verfahren die folgenden Schritte aufweist:
- Bereitstellen eines Substrates (1.1) und
- Herstellen eines Schichtstapels mit einer Elektrode (1.3), einer Gegenelektrode (1.7) sowie organischen Schichten (1.4 - 1.6) mit einem lichtemittierenden Bereich (1.5) auf dem Substrat (1.1), wobei die organischen Schichten (1.4 - 1.6) zwischen der Elektrode (1.3) und der Gegenelektrode (1.7) und in elektrischem Kontakt mit der Elektrode (1.3) und der Gegenelektrode (1.7) hergestellt werden, wobei die Schichtanordnung eine Licht streuende Funktionsschicht (1.2) mit flächig zufällig verteilten Metalloxid-Partikeln (10) aufweisend hergestellt wird,
**dadurch gekennzeichnet, dass** beim Herstellen der Licht streuenden Funktionsschicht (1.2) eine Metallschicht abgeschieden und erwärmt wird, derart, dass aus der zuvor abgeschiedenen Metallschicht die vereinzelten und flächig zufällig verteilten Metalloxid-Partikel (10) gebildet werden.

2. Verfahren nach Anspruch 1, **dadurch gekennzeichnet, dass** die Licht streuende Funktionsschicht (1.2) zwischen dem Substrat (1.1) und der Elektrode (1.3) hergestellt wird, die eine Grundelektrode bildet.

3. Verfahren nach Anspruch 1, **dadurch gekennzeichnet, dass** die Licht streuende Funktionsschicht (1.2) zwischen der Elektrode (1.3) und der Gegenelektrode (1.7) gebildet wird.

4. Verfahren nach Anspruch 1, **dadurch gekennzeichnet, dass** die Licht streuende Funktionsschicht (1.2) oberhalb der Gegenelektrode (1.7) hergestellt wird, die eine Deckelektrode bildet.

5. Verfahren nach Anspruch 1, **dadurch gekennzeichnet, dass** die Licht streuende Funktionsschicht (1.2) auf einer von dem Schichtstapel abgewandten Substratseite gebildet wird.

6. Verfahren nach mindestens einem der vorangehenden Ansprüche, **dadurch gekennzeichnet, dass** die Metalloxid-Partikel (10) als Metalloxid-Nanocluster gebildet werden.

7. Verfahren nach mindestens einem der vorangehenden Ansprüche, **dadurch gekennzeichnet, dass** die Licht streuende Funktionsschicht (1.2) als eine Lichtauskoppelschicht hergestellt wird.

8. Verfahren nach mindestens einem der vorangehenden Ansprüche, **dadurch gekennzeichnet, dass** auf der Licht streuenden Funktionsschicht (1.2) wenigstens eine Glättungsschicht gebildet wird, derart, dass mittels der wenigstens einen Glättungsschicht erhabene Strukturen der Licht streuende Funktionsschicht (1.2) zumindest teilweise geglättet werden.

9. Verfahren nach mindestens einem der vorangehenden Ansprüche, **dadurch gekennzeichnet, dass** die Schichtanordnung mit mindestens einer weiteren Licht streuende Funktionsschicht hergestellt wird, die mit flächig zufällig verteilten Metalloxid-Partikeln gebildet wird.

10. Verfahren nach mindestens einem der vorangehenden Ansprüche, **dadurch gekennzeichnet, dass** beim Herstellen der Licht streuenden Funktionsschicht (1.2) ein mehrstufiger Temperprozess ausgeführt wird, welcher einen Temperschritt im Vakuum und später einen Temperschritt in Luft- oder Sauerstoffumgebung umfasst.

## Claims

1. Method for producing an organic component having a layered arrangement, wherein the method includes the following steps:
- preparing a substrate (1.1) and
- producing a layer stack including an electrode (1.3), a counter electrode (1.7) and organic layers (1.4 - 1.6) having a light-emitting zone (1.5) on the substrate (1.1), wherein the organic layers (1.4 - 1.6) are produced between the electrode (1.3) and the counter electrode (1.7), and in electrical contact with the electrode (1.3) and the counter electrode (1.7), wherein the layer arrangement is produced with a light scattering functional layer (1.2) containing metal oxide particles (10) distributed randomly in two dimensions,
**characterized in that**, for producing the light scattering functional layer (1.2), a metal layer is deposited and the metal layer is warmed in such manner that the single metal oxide particles (10) distributed randomly in two dimensions are formed from the previously deposited metal layer.

2. Method according to claim 1, **characterized in that** the light scattering functional layer (1.2) is produced between the substrate (1.1) and the electrode (1.3) that functions as a base electrode.

3. Method according to claim 1, **characterized in that** the light scattering functional layer (1.2) is formed between the electrode (1.3) and the counter electrode (1.7).

4. Method according to claim 1, **characterized in that** the light scattering functional layer (1.2) is formed above the counter electrode (1.7), which functions as a covering electrode.

5. Method according to claim 1, **characterized in that** the light scattering functional layer (1.2) is formed on a side of the substrate facing away from the layer stack.

6. Method according to at least one of the preceding claims, **characterized in that** the metal oxide particles (10) have the form of metal oxide nanoclusters.

7. Method according to at least one of the preceding claims, **characterized in that** the light scattering functional layer (1.2) is prepared as a light decoupling layer.

8. Method according to at least one of the preceding claims, **characterized in that** at least one smoothing layer is formed on the light scattering functional layer (1.2) in such manner that protruding structures of the light scattering functional layer (1.2) are at least partially smoothed by the at least one smoothing layer.

9. Method according to at least one of the preceding claims, **characterized in that** the layer arrangement is produced having at least one further light scattering functional layer, which is formed with metal oxide particles distributed randomly in two dimensions.

10. Method according to at least one of the preceding claims, **characterized in that** a multistage tempering process is carried out when producing the light scattering functional layer (1.2), which process comprises a tempering step in a vacuum and a later tempering step in an air or oxygen environment.

## Revendications

1. Procédé de fabrication d'un composant organique se présentant sous forme d'un élément stratifié, le procédé comportant les étapes suivantes :
- mise à disposition d'un substrat (1.1) et
- réalisation, sur le substrat (1.1), d'un empilement de couches comportant une électrode (1.3), une contre-électrode (1.7) ainsi que des couches organiques (1.4 - 1.6) pourvues d'une zone émettrice de lumière (1.5), les couches organiques (1.4 - 1.6) étant réalisées entre l'électrode (1.3) et la contre-électrode (1.7) tout en étant en contact électrique avec l'électrode (1.3) et la contre-électrode (1.7), ledit élément stratifié étant réalisé de manière à ce qu'il comporte une couche fonctionnelle à diffusion de lumière (1.2) comportant des particules d'oxyde de métal (10) qui sont réparties aléatoirement en surface,
**caractérisé en ce que** la réalisation de la couche fonctionnelle à diffusion de lumière (1.2) implique le dépôt puis le réchauffement d'une couche métallique, de manière à former, à partir de la couche métallique précédemment déposée, les particules d'oxyde de métal (10) isolées qui sont réparties aléatoirement en surface.

2. Procédé selon la revendication 1, **caractérisé en ce que** la couche fonctionnelle à diffusion de lumière (1.2) est réalisée entre le substrat (1.1) et l'électrode (1.3) laquelle forme une électrode de base.

3. Procédé selon la revendication 1, **caractérisé en ce que** la couche fonctionnelle à diffusion de lumière (1.2) est réalisée entre l'électrode (1.3) et la contre-électrode (1.7).

4. Procédé selon la revendication 1, **caractérisé en ce que** la couche fonctionnelle à diffusion de lumière (1.2) est réalisée au-dessus de la contre-électrode (1.7) laquelle forme une électrode de couverture.

5. Procédé selon la revendication 1, **caractérisé en ce que** couche fonctionnelle à diffusion de lumière (1.2) est formée sur un côté du substrat qui se trouve à l'opposé du dudit empilement de couches.

6. Procédé selon au moins une des revendications précédentes, **caractérisé en ce que** les particules d'oxyde de métal (10) sont formées de manière à constituer un nanocluster d'oxyde de métal.

7. Procédé selon au moins une des revendications précédentes, **caractérisé en ce que** la couche fonctionnelle à diffusion de lumière (1.2) est réalisée sous forme d'une couche par laquelle sort la lumière.

8. Procédé selon au moins une des revendications précédentes, **caractérisé en ce que**, sur la couche fonctionnelle à diffusion de lumière (1.2), on forme au moins une couche de lissage, de manière à ce que l'au moins une couche de lissage permette de lisser au moins partiellement des structures en relief dont est pourvue la couche fonctionnelle à diffusion de lumière (1.2).

9. Procédé selon au moins une des revendications précédentes, **caractérisé en ce que** ledit élément stratifié est réalisé de manière à comporter au moins une autre couche fonctionnelle à diffusion de lumière laquelle est formée de manière à ce qu'elle comporte des particules d'oxyde de métal réparties aléatoirement en surface.

10. Procédé selon au moins une des revendications précédentes, **caractérisé en ce que** la réalisation de la couche fonctionnelle à diffusion de lumière (1.2) implique la mise en oeuvre d'un processus de traitement thermique à plusieurs étapes comprenant une étape de traitement thermique sous vide puis une étape de traitement thermique sous atmosphère d'air ou d'oxygène.
